(19) Europäisches Patentamt
European Patent Office
Office européen des brevets

(11) EP 1 796 337 A2

(12) **EUROPEAN PATENT APPLICATION**

(43) Date of publication:
**13.06.2007 Bulletin 2007/24**

(51) Int Cl.:
**H04L 27/00** $^{(2006.01)}$

(21) Application number: **06005741.1**

(22) Date of filing: **21.03.2006**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK YU** | (71) Applicant: **Andrew Telecommunication Products S.r.l.**<br>**20041 Agrate Brianza MI (IT)** |
| (30) Priority: **06.12.2005 IT MI20052346** | (72) Inventor: **Vannucchi, Alessandro**<br>**20040 Velate (IT)** |
| | (74) Representative: **Incollingo, Italo**<br>**Piazzale Lavater, 3**<br>**20129 Milano (IT)** |

(54) **Recovery of frequency jumps in QPSK modulated microwaves radio links**

(57)     The invention relates to a method for tracking Local Oscillators (LOs) phase hits and frequency clicks (fast frequency jumps) in Microwave Radio links using QPSK modulation. It consists of an AFC (Automatic Frequency Control) system, split into a "slow" carrier frequency recovery feedback subsystem (10) followed by a "fast" frequency tracking feedforward subsystem (11). The first subsystem is designed for recovering the average carrier frequency offset at the input of the demodulator, which is slowly varying with time, while the feedforward part of the AFC is designed for correcting fast frequency jumps, mainly due to microphonics of the local oscillators used in the up and/or down conversion of the modulated signal. A CTL (Carrier Tracking Loop) following the AFC system, will take care of all, if any, of the small frequency deviations introduced by the feedforward control.

Figure 1

## Description

### FILED OF THE INVENTION

The invention relates to a system to recover frequency jumps in QPSK modulated microwavws of radio link. More particularly the invention concerns a system for tracking Local Oscillators (LOs) phase hits and frequency clicks (fast frequency jumps) in Microwave Radio links using QPSK (Quadrature Phase Shift Keying) modulation with coherent detection. It consists basically of an AFC (Automatic Frequency Control) system, split into a "slow" carrier frequency recovery feedback subsystem followed by a "fast" frequency tracking feedforward subsystem. The first subsystem is designed for recovering the average carrier frequency offset at the input of the demodulator, which is slowly varying with time, while the feedforward part of the AFC is designed for correcting fast frequency jumps (frequency clicks), mainly due to microphonics of the local oscillators used in the up and/or down conversion of the modulated signal.

### BACKGROUND OF THE INVENTION

In microwave radio links usually the output carrier is obtained by multiplying several times a low frequency reference oscillator. This oscillator has quite heavy constraints about its phase noise characteristics, especially when coherent modulation schemes are used, thus in terms of its Q factor. The higher the Q factor the lower the phase noise but the higher the sensitivity to microphonic effects. Microphonics is usually mechanically induced (vibrations, shocks, etc.) and its effect is a sudden change of the resonant frequency of the oscillator. Due to the multiplication this effect is further increased on the output carrier. This frequency jump generates at the receiver a burst of errors or, in the worst case, the unlock of the system and consequently the loss of several data.

Moreover, performances of radio relay systems are mainly asserted in terms of the receiver sensitivity. Receiver sensitivity is defined as the signal level required for achieving a specified bit error rate target.

Perfect phase synchronization is not achievable in practice, so one must be prepared to accept some minor sensitivity degradation. Phase synchronization circuits are commonly implemented with a feedback loop. Such feedback circuits are generally referred to as "Carrier-Tracking Loops" (CTLs) or Costas' Loops.

The feedback loop iteratively adjusts the phase of a local reference to match the phase of the incoming signal.

The principle of operation of a CTL resembles the principle of the well-known Phase- lock Loop (PLL); the main difference is that PLLs are designed to track the phase of a periodic signal only, eventually embedded in additive noise, whereas CTLs must track the phase of a carrier-modulated signals.

In carrier- modulated signals the instantaneous phase of the carrier is varied in accordance to an informative data signal. Spurious phase variations are then superimposed to the carrier by thermal and oscillator noise. CTLs must reject unwanted (spurious) phase variations while retaining the information message.

Like for PLLs, a common implementation of CTLs is as second-order feedback systems. A second-order feedback system is able to lock onto a carrier- modulated signal even in the presence of a small frequency error between the transmitter's and the receiver's references. If the frequency error exceeds a certain threshold, the CTL doesn't lock and reception is inhibited.

Second-order systems can be described by two parameters: the natural frequency and the dumping factor. The amount of permitted detuning can be expressed as a function of these two parameters. Typical systems use a damping factor in the range between 0.7 and unity; if we set the damping factor to a prescribed value, say 1, the only free parameters is the natural frequency.

One can counteract larger frequency errors increasing the natural frequency. An inherent drawback of this solution is that the system becomes less tolerant to thermal noise effects, since the equivalent noise bandwidth of the system is proportional to the natural frequency.

If the natural frequency is set once for all, designers have to find a compromise between the two opposite requirements, that thermal noise rejection on one side and resiliency to frequency jumps on the other; obviously this is not an easy task.

Usually static frequency offsets, due to a not perfect frequency alignment between transmitter and receiver, are recovered at the receiver by an AFC. Usually AFCs act in a feedback mode. The disadvantage of feedback control is that it first must allow a deviation or error to appear before it can take action, since otherwise it would not know which action to make. Therefore, feedback control is by definition imperfect, whereas feedforward could in principle, but not in practice, be made error-free. For static control, or very slowly varying parameters, feedback control is the preferred one. In fact deviations from the goal usually do not appear at once, they tend to increase slowly, giving the controller the chance to act at an early stage when the deviation is still small and doesn't affect the performance of the system.

Feedforward is still necessary in those cases where perturbations are either discontinuous, or develop so quickly that any feedback reaction would come too late like the case of sudden frequency changes.

Feedforward control suffers from some disadvantages:

 1. It requires the identification of all possible disturbances and their direct measurement.
 2. Any changes in the parameters of a process cannot be compensated by a feedforward controller.
 3. Feedforward control requires a very good model of the process.

Feedback control, on the other hand, does not require knowledge or measurement of disturbances, it is not very sensitive to changes in process parameters or to errors in the process model. We would expect that a combined feedforward- feedback control system would have the performance advantages of the first, while retaining the insensitivity of the second to uncertainty and inaccuracies.

## DESCRIPTION OF THE RELATED ART

A solution to frequency jumps tracking, especially available if the CTL is implemented in a programmable digital processor, is based upon having two operating CTL modes; the first mode is designed to optimize thermal noise rejection and the other one is designed to maximize the robustness against frequency jumps. The system switches from one mode to the other on the basis of a run-time measurement of the operating Signal-to-Noise Ratio (SNR). This latter solution appears to be quite simple but in practice the switch management is quite critical. For example, it is necessary to set a "dead zone" or hysteresis region to prevent from random switching when the SNR fluctuates around the switching threshold. Moreover, at low SNR this system will not be able to track frequency jumps anymore, because its operating mode is optimized just for noise rejection.

Other systems for preventing frequency jumps are based on mechanical solutions, i.e. the local oscillators are mechanically dumped in order to decrease microphonic effects. These systems are usually quite expensive and space consuming.

## SUMMARY OF THE INVENTION

It is an object of the invention to provide a system to counteract for LOs frequency jumps in Microwave radio transmission using QPSK modulation with coherent detection. In particular the object is to provide a DSP (Digital Signal Processing) solution that can be easily implemented in programmable logic devices instead of more common but more complicated and expensive mechanical solutions (mechanical dumpers). Another object of the invention is to reach the target without interfering with the CTL parameters.

These objects are reached by placing in the demodulator, in front of the CTL, a combined feedback-feedforward AFC (Automatic Frequency Control).

The feedback part is designed for recovering the average slow time varying frequency offset at the input of the demodulator. This allow, the feedforward part (and also the CTL) to work more properly. The feedforward part is able to track fast frequency variations, so to compensate for fast frequency jumps (frequency clicks).

Briefly the present invention provides a solution for tracking fast frequency jumps or frequency clicks without acting on the CTL parameters i.e. leaving the CTL optimized for joint thermal noise rejection and phase noise traking.

Generally in cascaded control systems the feedforward control precedes the feedback one, for the reasons stated above, whereas our system consists of a cascaded feedback-feedforward control. This can be actually done because the AFC system is followed by a CTL (Carrier-Tracking Loop), for the carrier phase recovery. The CTL will take care of all, if any, of the small frequency deviations introduced by the feedforward control.

The main characteristics of the invention are recited in the appended claims which are to be considered also herein incorporated.

## BRIEF DESCRIPTION OF THE FIGURES

The advantages and further features of the invention will clearly appear from the following description of the preferred embodiments represented for illustrative and not-limiting purpose in the accompanying drawings in which the single figures show respectively:

- Fig. 1, a Block dia gram of the invention;
- Fig. 2, Experimental results for a frequency click after a impulsive shock of 100mJ;
- Fig. 3, Model of the frequency click used for the simulations;
- Fig. 4, Constellation after the CTL, NO feedforward enabled, SNR=60dB;
- Fig. 5, Constellation after the CTL, feedforward enabled, SNR=60dB; and
- Fig. 6, Constellation after the CTL, feedforward enabled, SNR=20dB.

## DETAILED DESCRIPTION OF THE INVENTION

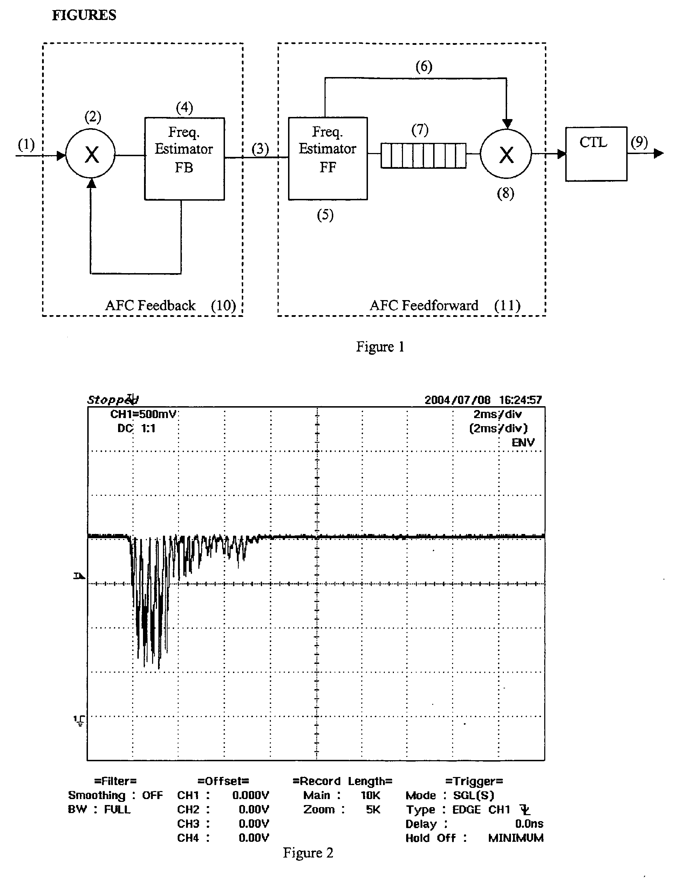

The embodiment of the combined feedback-feedforward AFC system according to the invention is depicted in figure 1.

A QPSK modulated signal (1) is fed (after being sampled) into a first AFC feedback subsystem (10), composed of a digital frequency estimator (4) and a complex multiplier (2). The estimated frequency offset of the input signal is cancelled by the feedback loop. The estimated frequency offset in this case is averaged over many symbols, both for noise immunity and also because the frequency offset is very slow varying with time. The signal (3) at the output of the first AFC subsystem is fed into a second AFC subsystem (11). The digital frequency estimator in this case is sufficiently fast for tracking sudden frequency changes. The frequency error (6) multiplies the signal, delayed by a delay line (7) for taking into account the processing delay of the estimator. Also this second multiplication is complex, of course. The output signal will finally fed into a CTL (Carrier tracking Loop), and at its output we have the completely derototated signal (9).

## Preferred Embodiment

The preferred embodiment makes use of a frequency detection algorithm (both in the feedback and the feedforward estimation) described in the paper:

"Digital Frequency Estimation in burst mode QPSK transmission", S. Bellini, C. Molinari, G. Tartara; IEEE Transaction on Communications, vol. 38, No 7, July 1990.

This algorithm is easy to be implemented in a digital device like an FPGA (Field Programmable Gate Array). In our embodiment the first estimation is averaged over one thousand of symbols while the second estimation in the feedforward correction is averaged over 16 symbols. The delay line (7) length is 8 symbols.

Of course, in principle, any frequency detection algorithm suitable for QPSK modulation can be used.

## CONCLUSIONS AND SIMULATION RESULTS

The first step for understanding if the system described in the invention is effective in correcting LOs phase hits and frequency clicks, is to have a realistic model of the frequency jumps of an oscillator due to microphonic effects and use this model to run simulations. Our model was based on experimental measurements carried out on a MW radio at 38GHz, after an impulsive shock with energy of 100mJ (this is the specified energy for this kind of shock test). Figure 2 is the carrier frequency deviation after the shock, measured by a frequency discriminator, with a sensitivity of 100 kHz/V.

Since LOs are mechanical systems, they have a resonant frequency, thus apart from the amplitude of the frequency jump, also a dumped oscillation with a characteristic frequency must be taken into account in our model.

The model used for the time behaviour of the frequency deviation after the shock (frequency click) was:

$$f_{click} = A \sin(2\pi f_r t) e^{-(\alpha t)}$$

Where A, fr, $\alpha$ are three parameters.

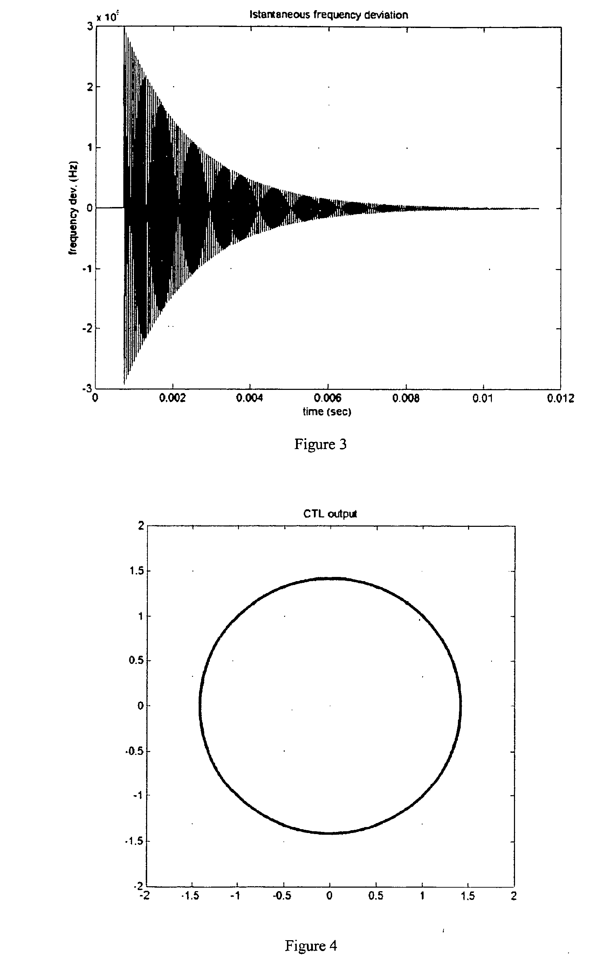

For our simulations we have considered a very severe model of the frequency click (figure 3) compared to our experimental results. The parameters set for the instantaneous frequency deviation were:

A=300kHz;
$f_r$= 20kHz;
$\alpha$ = 2x10$^{-4}$;

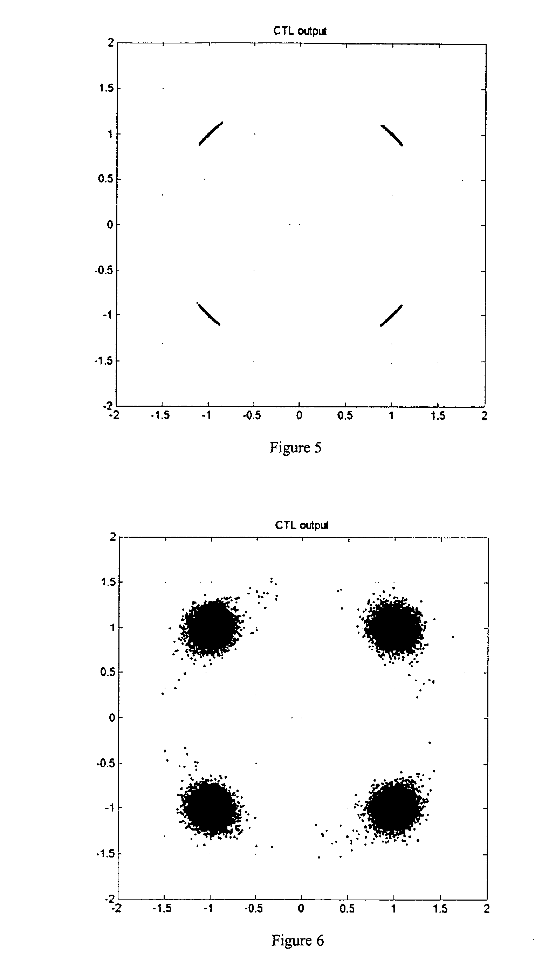

The simulations have been carried out for a QPSK signal with a symbol rate of 2.8 Mbaud/s. As it can be seen from figure 4, disabling the feedforward part of the AFC (like in standard systems), the constellation at the output of the CTL undergoes a rotation because the AFC (and the CTL) are not able to compensate for the sudden change of the input instantaneous frequency. Figure 5 shows how, enabling the feedforward part of the AFC, the system is able to compensate for the frequency click. Figure 4 and 5 were simulated with almost no noise (SNR=60dB). In figure 6 some noises have been added to the QPSK signal, in order to verify the robustness of the system to noise (SNR=20dB). The results were very satisfactory. Obviously the described and represented embodiments can undergo those changes, additions and the like which are in the reach of the hand of the mean technical man of this Art, which however are to be considered as naturally comprised or falling in the scope and spirit of the following claims.

## Claims

1. A system to track and correct frequency differences between local oscillators (LO$_s$) of the transmitter (TX) and receiver (RX) of radio link microwaves with modulation QPSK (Quadrature Phase Shift Keying) and coherent demodulation, said differences being either of small magnitude and slowly variable (thus low small frequency shifts) or of high entity and suddenly variable (frequency jumps), **characterized by** at least:

   a) a subsystem (SSL) for the recovery of said small, slowly time variable difference;
   b) a subsystem (SSV) to track and recover the big, quick variable differences (Frequency Jumps);
   c) a subsystem to track the carrier, in form of a CTL (Carrier Tracking loop).

2. A system according to claim 1, **characterized in that** said subsystem a) (SSL) is an Automatic Frequency Control (AFC) with closed ring (Feedback).

3. A system according to claim 1, characterirized in that the subsystem b) (SSV) is an Automatic Frequency Control with open ring (Feedforward).

4. A system according to at least one of the preceding claims, **characterized in that** said (SSL) subsystem is upstream said subsystem (SSV)

5. A system according to at least one of the preceding claims, **characterized in that** said (CTL) subsystem is downstream said subsystem (SSV).

**FIGURES**

Figure 1

Figure 2

Figure 3

Figure 4

Figure 5

Figure 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. BELLINI ; C. MOLINARI ; G. TARTARA.** Digital Frequency Estimation in burst mode QPSK transmission. *IEEE Transaction on Communications,* July 1990, vol. 38 (7